# EUROPEAN PATENT APPLICATION

(11) **EP 1 258 891 A2**
(43) Date of publication of application: **20.11.2002**
(21) Application number: 02253405.1
(22) Date of filing: 15.05.2002
(51) Int. Cl.: H01C 7/00, H05K 1/16

(54) **Resistors**

(30) Priority: 17.05.2001 US 291586 P
(71) Applicant: Shipley Co. L.L.C., Marlborough, MA 01752 (US)
(72) Inventor: Schemenaur, John, Scottsdale, AZ 85267 (US); Senk, David D., Mission Viejo, California 92692 (US)
(74) Representative: Kent, Venetia Katherine

(57) **Abstract**

Resistive materials having a plurality of perforations are provided. Such resistive materials are useful in the manufacture of resistors. These resistors are particularly suitable for use as resistors embedded in printed wiring boards.

## Description

### Background of the Invention

The present invention relates generally to the field of resistive materials. In particular, the present invention relates to the field of resistive materials suitable for use as embedded resistors in electronic devices.

Printed circuit boards typically include large numbers of electronic devices which are commonly surface mounted and also additional components which may be present in the form of active layers within each printed circuit board. The requirements for the devices and components in such printed circuit boards are subject to conventional electronic design restraints. In particular, many of the surface mounted devices and other components on such printed circuit boards commonly require coupling with individual resistors in order to achieve their desired function.

The most common solution to this problem in the prior art has been the use of individual resistors as additional surface mounted components on the printed circuit boards. Design of the printed circuit boards has further required the provision of through-holes in order to properly interconnect the resistors. In this regard, the resistors may be interconnected between any combination of surface devices or components or active components or layers formed on or within the printed circuit boards.

As a result, the complexity of the printed circuit boards has increased and at the same time the available surface area of the printed circuit boards for other devices has decreased or else the overall size of the printed circuit boards has increased to accommodate necessary surface devices and components including resistors.

One solution to this has been the use of planar resistors preferably formed on internal layers of the printed circuit boards in order to replace surface mounted resistors as described above while making surface portions of the printed circuit boards free for other uses. For example, U.S. Patent No. 4,808,967 (Rice et al.) discloses a printed wiring board having a support layer, a layer of electrical resistance material adhering to the support layer, and a conductive layer adhering to the electrical resistance layer.

Although such planar resistors provide advantages in certain applications over discrete surface mounted resistors, they have still tended to result in relative increases in the complexity and space demands on the printed circuit boards. For example, if the planar resistors are formed on a surface layer of the printed circuit board, it is of course possible to arrange an active surface device over the resistor. However, that surface portion of the printed circuit board occupied by the planar resistor must be dedicated to the planar resistor itself. Accordingly, that portion of the board is not available for mounting pads, through-holes or the like.

One approach to solving this board space problem has been to take advantage of the space around through holes. For example, U.S. Patent No. 5,347,258 (Howard et al.) discloses a simplified design for the resistor elements while reducing surface requirements within the printed circuit board by forming the resistor elements in combination with existing through-holes present in the printed circuit boards for interconnecting surface devices or components with conductive layers on or in the printed circuit board. The resistors disclosed are annular in design, where the center of the ring is a through-hole.

A variety of resistive materials are used in conventional planar resistors. A problem with many of the conventional resistive materials is that they do not always adhere well to the support on which they are applied, or to the dielectric material that is disposed on the resistor. This can be particularly problematic in multilayer printed wiring boards where such poor adherence may result in delamination.

There is thus a need for planar resistors that adhere well to both the support and a dielectric layer, and that reduce or eliminate the problem of delamination due to such adhesive failures.

### Summary of the Invention

It has been surprisingly found that planar resistors can be prepared from conventional resistive materials which show decreased tendency toward delamination when they are embedded in an organic dielectric material.

In one aspect, the present invention provides a resistive material having a plurality of perforations. Preferably, such resistor is a thin film resistor.

In another aspect, the present invention provides a resistor having a resistive material and a pair of electrodes, wherein the resistive material has a plurality of perforations.

In still another aspect, the present invention provides a printed wiring board including one or more resistors embedded in a dielectric layer, wherein the resistors include a resistive material having a plurality of perforations.

In a further aspect, the present invention provides a method of manufacturing a printed wiring board including the steps of applying a resistor having a resistive material having a plurality of perforations to a printed wiring board substrate; and then applying a layer of an organic dielectric material over the resistor. Preferably, the resistor is applied to a printed wiring board substrate surface, such surface including a first dielectric material.

In yet a further aspect, the present invention provides an electronic device including one or more resistors having a resistive material having a plurality of perforations.

In still a further aspect, the present invention provides an electronic device including one or more printed wiring boards including one or more resistors embedded in an organic dielectric layer, wherein the resistors include a resistive material having a plurality of perforations.

### Brief Description of the Drawing

Fig. 1 illustrates a resistor having a resistive material having circular perforations.

Fig. 2 illustrates a resistor having a resistive material having perforations in the form of slits.

### Detailed Description of the Invention

As used throughout this specification, the following abbreviations shall have the following meanings, unless the context clearly indicates otherwise: °C = degrees centigrade; ° F = degrees Fahrenheit; nm = nanometer; µm = micron = micrometer; Å = angstrom; Ω = Ohms; Ω/□ = Ohms per square; M = molar; wt % = percent by weight; and mil = 0.001 inch.

The terms "printed wiring board" and "printed circuit board" are used interchangeably throughout this specification. By "substantially orthogonal" it is meant directions that are substantially at right angles to each other, i.e. 90° ± 15°, preferably 90° ± 10°, more preferably 90° ± 5° and still more preferably 90° ± 3°. Unless otherwise noted, all amounts are percent by weight and all ratios are by weight. All numerical ranges are inclusive and combinable in any order, except where it is obvious that such numerical ranges are constrained to add up to 100%.

Resistors typically have an electrically resistive material portion and a pair of electrodes. One of the electrodes is disposed at one end of the resistive material and the remaining electrode is disposed at the opposite end of the resistive material. The present invention provides a resistor having a resistive material and a pair of electrodes, each electrode being disposed at opposite ends of the resistive material, wherein the resistive material includes a plurality of perforations. By "perforation" it is meant any hole or void within the resistive material. Accordingly, "perforation" refers to a hole or void surrounded by resistive material. Any type or size of perforation may be used. For example, such perforations may be circular, trapezoidal, polygonal, square, rectangular such as slits, slots and the like, and elliptical, as well as any of a variety of other shapes. These exemplary perforations are used in their general sense, i.e. "circular" includes perforations that are generally circular as well as perfect circles. The term "square" and "rectangular" are intended to include perforations that are generally square and generally rectangular, e.g. squares or rectangles having rounded (or radiused) corners as well as perfect squares and rectangles. "Slots" and "slits" are used interchangeably and refer to generally rectangular structures having a major dimension much greater than a minor dimension and having right-angle or radiused corners or even radiused or curved sides in the minor dimension. Circular perforations and perforations in the form of slits are particularly suitable. It will be appreciated that combinations of different perforations may be used advantageously in the present invention, such as a combination of circular perforations and slits.

Any number of perforations may be used in the present invention provided that at least 2 perforations are present. There is no upper limit to the number of perforations that may be used. The perforations may be any of a wide variety of sizes. No particular size or dimension of perforation is preferred. In certain instances, it may be desired to use perforations having varying sizes within the resistive material. For example, a resistor may be desired where the resistive material has as perforations a mixture of circular perforations and slits, or in the alternative, a mixture of slits having varying dimensions such as a mixture of short and long slits.

No particular pattern of perforations in the resistive material is required. The perforations may be in a row or a series of rows, staggered, or randomly placed in the resistive material. "Staggered" refers to rows of perforations wherein a row is offset as compared to other rows immediately adjacent to such row. The staggered perforations may be offset by any amount. In general, such offset may be an amount equal to a fraction of the dimension of the perforation, an amount equal to the dimension of the perforation or an amount greater to the dimension of the perforation.

In one embodiment, the present invention provides a resistive material having a first resistivity in a first direction and a second resistivity in a second direction, wherein the second direction is substantially orthogonal to the first direction and wherein the resistive matrial includes a plurality of perforations. The resistivity of the present resistive materials is axis dependent. Thus, the present materials have a first resistivity in the X-direction and a very different resistivity in the Y-direction i.e., in a direction substantially at right angles to the first (or X) direction. Such difference in resistivity is achieved by design of the perforations in the resistive material.

For example, when there is no straight line path of resistive material from one electrode to the other, the resistivity of the resistor is higher than a corresponding resistor that does have a straight line path of resistive material between the electrodes. Accordingly, when the perforations are slits, such slits may be placed such that they are substantially orthogonal, and preferably orthogonal, to the electrodes or substantially parallel, and preferably parallel, to the electrodes. By "substantially parallel" it is meant that a row of slits and an electrode are nearly parallel to each other.

A wide variety of resistive materials are suitable for use in the present invention. Suitable resistive materials include, but are not limited to, a mixture of a conductive material and a minor amount of a highly resistive (dielectric) material. A very small amount of the highly resistive material, e.g., about 0.1 wt % to about 20 wt %, very profoundly reduces the conductive properties of the conducting material. Although noble metals are conductors, it is found that in depositing noble metals along with relatively minor amounts of oxides, such as silica or alumina, the deposited material becomes highly resistive. Accordingly, metals, such as platinum, containing minor amounts, e.g., 0.1%-5% of an oxide, can serve as resistors in printed circuit boards. However, For example, platinum, though an excellent conductor, when co-deposited with between 0.1 and about 5 wt % silica, serves as a resistor, the resistance being a function of the level of silica co-deposited. Any conductive material is suitable, such as, but not limited to, platinum, iridium, ruthenium, nickel, copper, silver, gold, indium, tin, iron, molybdenum, cobalt, lead, palladium, and the like. Suitable dielectrics include, but are not limited to, metal oxides or metalloid oxides, such as silica, alumina, chromia, titania, ceria, zinc oxide, zirconia, phosphorous oxide, bismuth oxide, oxides of rare earth metals in general, phosphorus, and mixtures thereof.

Preferred electrically resistive materials are nickel-based or platinum-based, i.e., the major material is nickel or platinum, respectively. Suitable preferred resistive materials are nickel-phosphorus, nickel-chromium, nickel-phosphorus-tungsten, ceramics, conductive polymers, conductive inks, platinum-based materials such as platinum-iridium, platinum-ruthenium and platinum-iridium-ruthenium. Preferred platinum-based materials contain from about 10 to 70 mole percent iridium, ruthenium or mixtures thereof, and preferably 2 mole percent to 50 mole percent, calculated relative to platinum being 100 percent. If ruthenium is used alone (without iridium), it is preferably used at between about 2 and about 10 mole percent calculated relative to platinum being 100 percent. If iridium is used alone (without ruthenium), it is preferably used at between about 20 and about 70 mole percent calculated relative to platinum being 100 percent. In the resistive materials in accordance with the invention, the iridium, ruthenium or mixtures thereof exist in both elemental form and in oxide form. Typically, the iridium, ruthenium or mixtures thereof are from about 50 to about 90 mole percent elemental metal and from about 10 to about 50 mole percent oxide(s) of the iridium, ruthenium or mixtures thereof.

The thickness of the resistive material layer may vary over a wide range. Preferably, the material has a thickness of up to 1 mil, although greater thicknesses may be used. For use in embedded resistors, the material is typically at least about 40 Å thick. In general, the thickness of the material layer is from 40 to 100,000 Å (10 microns), preferably from 40 to 50,000 Å, and more preferably from 100 to 20,000 Å.

While the resistive material layer may be self-supporting, it is typically too thin to be self-supporting and must be deposited on a substrate which is self-supporting. The resistive materials are typically disposed on a conductive material substrate, such as a metal foil. Other suitable conductive materials are well known to those skilled in the art. Suitable metal foils include, but are not limited to, copper foil, nickel foil, silver foil, gold foil, platinum foil, and the like. Conductive metal foils suitable for use in the present invention may have a wide range of thicknesses. Typically, such conductive metal foils have nominal thicknesses ranging from 0.0002 to 0.02 inches. Metal foil thicknesses are often expressed in terms of weights. For example, suitable copper foils have weights of from 0.125 to 14 ounces per square foot, more preferably 0.25 to 6 ounces per square foot, and still more preferably from 0.5 to 5 ounces per square foot. Particularly suitable copper foils are those having weights of 3 to 5 ounces per square foot. Suitable conductive metal foils may be prepared using conventional electrodeposition techniques and are available from a variety of sources, such as Oak-Mitsui or Gould Electronics.

The conductive material substrates may further include a barrier layer. Such barrier layer may be on the first side of the conductive material, i.e. the side nearest the resistive material, the second side of the conductive layer or on both sides of the conductive layer. Barrier layers are well known to those skilled in the art. Suitable barrier layers include, but are not limited to, zinc, indium, tin, nickel, cobalt, chromium, brass, bronze and the like. Such barrier layers may be deposited electrolytically, electrolessly, by immersion plating, by sputtering, by chemical vapor deposition, combustion chemical vapor deposition, controlled atmosphere chemical vapor deposition, and the like. Preferably, such barrier layers are deposited electrolytically, electrolessly or by immersion plating. In one embodiment, when the conductive layer is a copper foil, it is preferred that a barrier layer is used.

Following the application of a protective barrier layer, a protective layer of chromium oxide may be chemically deposited on the barrier layer or the conductive material. Finally, a silane may be applied to the surface of the conductive material/barrier layer/optional chromium oxide layer in order to further improve adhesion. Suitable silanes are those disclosed in U.S. Patent No. 5,885,436 (Ameen et al.).

The resistive material may be deposited on the substrate by a variety of means, such as sol-gel deposition, sputtering, chemical vapor deposition, combustion chemical vapor deposition ("CCVD"), controlled atmosphere combustion chemical vapor deposition ("CACCVD"), spin coating, roller coating, silk screening, electroplating, electroless plating and the like. For example, nickel-phosphorus resistive materials may be deposited by electroplating. See, for example, International Patent Application No. WO 89/02212. In one embodiment, it is preferred that the first material is deposited by CCVD and/or CACCVD. The deposition of resistive materials by CCVD and/or CACCVD is well known to those skilled in the art. See, for example, U.S. Patent No. 6,208,234 (Hunt et al.) for a description of such processes and apparatuses used.

CCVD has the advantages of being able to deposit very thin, uniform layers which may serve as the dielectric layers of embedded capacitors and resistors. The material can be deposited to any desired thickness; however, for forming resistive material layers by CCVD, thicknesses seldom exceed 50,000 Å (5 microns). Generally film thicknesses are in the 100 to 10,000 Å range, most generally in the 300 to 5000 Å range. Because the thinner the layer, the higher the resistance and the less material is needed, e.g., platinum, the ability to deposit very thin films is an advantageous feature of the CCVD process. The thinness of the coating also facilitates rapid etching in processes by which discrete resistors are formed.

For resistive material which is a mixture of a conductive metal and a minor amount of a dielectric material, the metal must be capable of being deposited as a zero valence metal from an oxygen-containing system if the resistive material is to be deposited by CCVD or CACCVD. The criteria for deposition in the zero valence state using a flame is that the metal must have a lower oxidation potential than the lower of the oxidation potential of carbon dioxide or water at the deposition temperature. (At room temperatures, water has a lower oxidation potential; at other temperatures carbon dioxide has a lower oxidation potential.) Zero valence metals which can be readily deposited by CCVD are those having oxidation potentials about equal to silver or below. Thus, silver, gold, platinum and iridium can be deposited by straight CCVD. Zero valence metals having somewhat higher oxidation potentials may be deposited by CACCVD which provides a more reducing atmosphere. Nickel, copper, indium, palladium, tin, iron, molybdenum, cobalt, and lead are best deposited by CACCVD. Herein, metals also include alloys that are mixtures of such zero-valence metals. Silicon, aluminum, chromium, titanium, cerium, zinc, zirconium, magnesium, bismuth, rare earth metals, and phosphorous each have relatively high oxidation potentials, such that if any of the metals mentioned above are codeposited with the appropriate precursors for the dielectric dopants, the metals will deposit in the zero valence state and the dopant will deposit as the oxide. Thus, even when no flame is used the dielectric needs to have a higher oxidation, phospidation, carbidation, nitrodation, or boridation potential, to form the desired two phases.

For more oxygen-reactive metals and alloys of metals, CACCVD may be the process of choice. Even if the metal can be deposited as a zero valence metal by straight CCVD, it may be desirable to provide a controlled atmosphere, i.e., CACCVD, if the substrate material on which it is to be deposited is subject to oxidation. For example, copper and nickel substrates are readily oxidized, and it may be desired to deposit onto these substrates by CACCVD.

Another type of resistive material which can be deposited as a thin layer on a substrate by CCVD is "conductive oxides". In particular, Bi₂Ru₂O₇ and SrRuO₃ are conductive oxides which may be deposited by CCVD. Although these materials are "conductive", their conductivity is relatively low when deposited in amorphous state; thus, a thin layer of such mixed oxides can be used to form discrete resistors. Like conductive metals, such "conductive oxides" may be doped with dielectric materials, such as metal or metalloid oxides, to increase their resistivity. Such mixed oxides may be deposited either as amorphous layers or as crystalline layers, amorphous layers tending to deposit at low deposition temperatures and crystalline layers tending to deposit at higher deposition temperatures. For use as resistors, amorphous layers are generally preferred, having higher resistivity than crystalline materials. Thus, while these materials are classified as "conductive oxides" in their normal crystalline state, the amorphous oxides, even in un-doped form, may produce good resistance. In some cases it may be desired to form low resistance, 1 to 100 Ω, resistors and a conduction-enhancing dopant, such as platinum, gold, silver, copper or iron, may be added. If doped with dielectric material, e.g., metal or metalloid oxides, to increase resistivity of the conducting oxides, or conduction-enhancing material to decrease resistivity of the conducting oxides, such homogeneously mixed dielectric or conduction-enhancing material is generally at levels between 0.1 wt % and 20 wt % of the resistive material, preferably at least 0.5 wt %.

There are a variety of other "conducting materials" which though electrically conducting, have sufficient resistivity to form resistors in accordance with the present invention. Examples include yttrium barium copper oxides and La₁₋ₓSrₓCoO₃, 0 ≤x≤1, e.g., x = 0.5. Generally, any mixed oxide which has superconducting properties below a critical temperature can serve as electrically resistive material above such critical temperature. Deposition of such a variety of resistive materials is possible with proper selection of precursors selected from those described herein above.

To produce a metal/oxide resistive material film using a CCVD or CACCVD process, a precursor solution is provided which contains both the precursor for the metal and the precursor for the metal or metalloid oxide. For example, to produce platinum/silica films, the deposition solution contains a platinum precursor, such as platinum(II)-acetylacetonate or diphenyl-(1,5 cyclooctadiene) platinum (II) [Pt(COD)] and a silicon-containing precursor, such as tetraethoxysilane. Suitable precursors for iridium and ruthenium include, but are not limited to, tris (norbornadiene) iridium (III) acetyl acetonate ("IrNBD"), and bis (ethylcyclopentadienyl) ruthenium (II). The precursors are mixed generally according to the ratio of metal and enhancing material to decrease the resistivity of the material being deposited, an additional precursor is provided so as to produce minor amounts of the metal oxide or metalloid oxide, e.g., between 0.1 and 20 wt %, preferably at least about 0.5 wt %, of the deposited doped conducting metal oxide. The precursors typically are co-dissolved in a single solvent system, such as toluene or toluene/propane to a concentration (total of platinum, iridium, and/or ruthenium precursors) of from about 0.15 wt% to about 1.5 wt%. This solution is then typically passed through an atomizer to disperse the precursor solution into a fine aerosol and the aerosol is ignited in the presence of an oxidizer, particularly oxygen, to produce the platinum and iridium, ruthenium or mixture thereof zero valence metals(s) and oxide(s). See, e.g. U.S. Patent No. 6,208,234 B1 (Hunt et al.), herein incorporated by reference, for a more complete description of the CCVD process.

Perforations may be made in the resistive material by any suitable means, such as, but not limited to, mechanical drilling, laser drilling, etching such as wet chemical etching or plasma etching, photolithography followed by etching, and the like. Mechanical drilling and laser drilling are well-known procedures in the manufacture of printed wiring boards. Etching may be accomplished by selecting the appropriate etchant for the resistive material. Such etchant may be applied to the resistive material in such a manner as to provide the desired pattern of perforations. For example, the etchant may be applied selectively, such as by ink jet printing, to provide the desired pattern. Alternatively, a photoresist may be applied to the resistive material and exposed through a mask using an appropriate wavelength of actinic radiation. The mask may provide a plurality of circular holes, slits, or other suitable perforations, or a mixture of such perforations. The imaged resist is then developed to provide the desired perforation pattern, i.e. areas bared of resist. Resistive material is then removed from the areas bared of resist, such as by etching, to form the perforations. Such etching may be chemical etching (wet etching) or plasma etching (dry etching). Such techniques are well-known to those skilled in the art. In certain instances, laser drilling is the preferred method of forming the perforations.

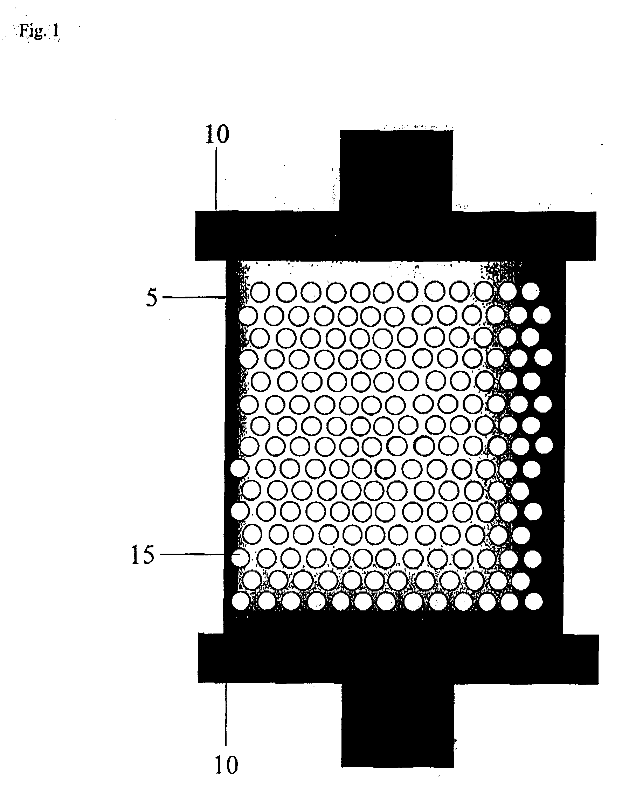

Fig. 1 illustrates one embodiment of the present invention. A resistor is shown in Fig. 1 having a resistive material portion, e.g. a silica doped platinum material, **5** and a pair of copper electrodes **10,** each electrode **10** being disposed at opposite ends of resistive material **5.** Resistive material **5** has a plurality of circular perforations **15.** The circular perforations **15** are formed by laser drilling of resistive material **5.**

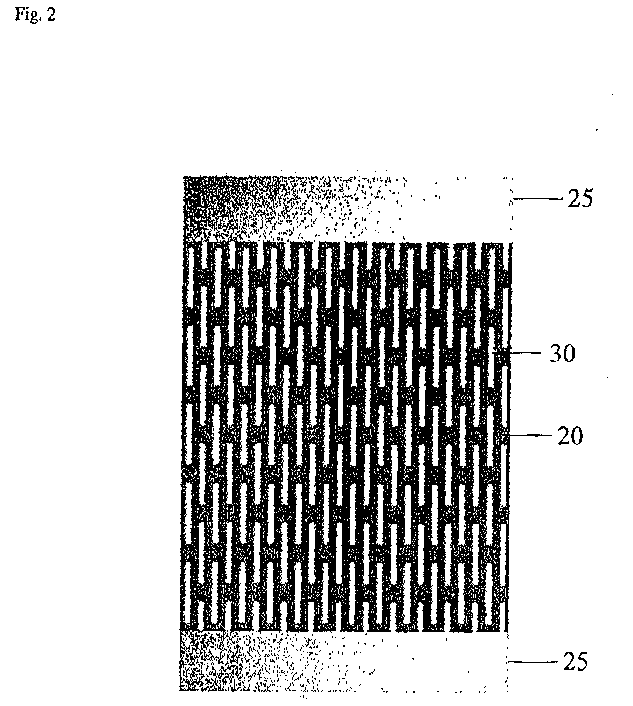

Fig. 2 illustrates a second embodiment of the present invention. The resistor of Fig. 2 has a resistive material portion **20** and a pair of electrodes **25,** one electrode **25** disposed at opposite ends of the resistive material **20.** Resistive material **20** has a plurality of perforations in the form of slits **30.**

In an example of the present invention, a conventional nickel-phosphorus resistive material is applied, such as by electroplating, to a conductive substrate or a dielectric layer. A laser, which is programmed to drill the desired size perforations in the desired pattern, is used to drill a plurality of perforations in the resistive material. The resistive material may be trimmed to the desired size before or after such perforations are formed. If a conductive substrate is used, such substrate may be removed from the resistive material prior to or after formation of the perforations. If the resistive material is not free-standing or self-supporting, the conductive material is usually removed after formation of the perforations or after the resistive material has otherwise been supported, such as by lamination to another substrate, such as an organic dielectric layer. Electrodes may be formed on, adhered to or otherwise provided to the resistive material prior to or after formation of the perforations, to form resistors.

Perforated resistors offer many advantages over conventional resistors. The perforations may be used as a means to trim or adjust the resistance of the resistive material to provide a desired resistivity. The present resistors are particularly suitable for use as embedded resistors in the manufacture of printed wiring boards. The perforations provide sites for through-flow of an organic dielectric material, such as an epoxy or polyimide resin. Such through-flow of dielectric material facilitates bonding between organic dielectric layers on each side of the embedded resistive material. Thus the dielectric layers are in intimate contact or communicate through the perforations in the resistive material. Such intimate contact or communication provides increased adhesion between the dielectric layers, thereby reducing or eliminating delamination in the area of the embedded planar resistor.

The present perforated resistive materials are suitable for the manufacture of resistors, and in particular thin film, embeddable resistors useful in printed wiring board manufacture. Thin film resistors typically have a total thickness of structured resistive material of 4 µm or less, preferably 2 µm or less, more preferably 1 µm or less and even more preferably 0.5 µm or less.

Resistors typically include a pair of electrodes, each electrode being disposed at opposite ends of a resistive material. Such electrodes may be provided in a variety of ways, such as by formation directly on the resistive material or directly formed from an underlying conductive substrate. By way of example, areas of the resistive material to receive the electrode may be catalyzed so that electrodes are deposited, formed, or adhered only to those areas. Alternatively, areas that are not to receive the electrode may be masked off, such as by a resist, and the electrode deposited, formed or adhered to the unmasked areas.

Suitable electrodes may be formed by any conductive material such as a conductive polymer or a metal. Exemplary metals include, but are not limited to, copper, gold, silver, nickel, tin, platinum, lead, aluminum and mixtures and alloys thereof. "Mixtures" of such metals include non-alloyed metal mixtures and two or more layers of individual metals as in a multilayer electrode. An example of a multilayer electrode is copper having a layer of silver or a layer of nickel on the copper followed by a layer of gold. Such electrodes are typically formed by deposition of a conductive material. Suitable deposition methods include, but are not limited to, electroless plating, electrolytic plating, chemical vapor deposition, CCVD, CACCVD, screen printing, ink jet printing, roller coating and the like. When a conductive paste is used to form the electrode, it is suitably applied by screen printing, ink jet printing, roller coating and the like.

As described above, when the resistive material is not self-supporting, it is typically applied to a substrate. Conductive substrates are particularly suitable for subsequent formation of resistors, particularly thin film resistors as the conductive substrates can be used to form the electrodes. When conductive substrates are used, electrode formation is generally accomplished using a photoresist which is used to form a resist pattern over the layer of resistive material and using an appropriate etchant to remove the resistive material in areas not covered by the resist. For metal/oxide resistive material layers, the etchant chosen is an etchant for the metal component of the resistive material. Typically such etchants are acids or Lewis acids, e.g., FeCl₃ or CuCl₂ for copper. Nitric acid and other inorganic acids (e.g., sulfuric, hydrochloric, and phosphoric) may be used to etch nickel, a variety of other metals which may be deposited as well as conductive oxides.

Noble metals, by their non-reactive nature, are difficult to etch, as is required in many processes for production of printed circuit boards. Aqua regia is a suitable etchant for metals, particularly noble metals, in printed circuit board processes. Aqua regia is made from two well-know acids: 3 parts concentrated (12M) hydrochloric acid (HCl) and 1 part concentrated (16M) nitric acid HNO₃. Thus, the molar ratio of hydrochloric acid to nitric acid is 9:4, although slight variations from this ratio, i.e., 6:4 to 12:4 would be acceptable for etching purposes in accordance with the invention. Because of its corrosive nature and limited shelf life, aqua regia is not sold commercially, but must be prepared prior to use. To reduce its corrosiveness, the aqua regia may be diluted with water up to about a 3:1 ratio of water to aqua regia. On the other hand, the noble metals, such as platinum, are not etched by many of the materials suitable for etching copper, such as FeCl₃ or CuCl₂, thereby allowing for a variety of selective etching options in forming the present resistors. The speed of etching will depend upon several factors including the strength of the aqua regia and the temperature. Typically, aqua regia etching is conducted at a temperature of 55 to 60° C, although this may be varied depending upon the application.

By way of example, the circuitization process begins with a conductive foil, such as a copper foil, to which a layer of a electrically resistive material has been deposited, such as by electroplating, CCVD or CACCVD. Perforations are then formed in the resistive material and optionally in the conductive foil by any of the methods described above to form a perforated resistive material. Photoresist layers are then applied to both sides, i.e. to the resistive material and to the conductive foil. The photoresist covering the resistive material layer is exposed to patterned actinic radiation while the photoresist covering the conductive foil is blanket-exposed to actinic radiation. The photoresists are then developed, giving a structure with a patterned photoresist layer covering the resistive material layer and the blanket-exposed photoresist layer protecting the conductive foil.

The resistive material layer is then selectively etched from areas where the photoresist had been removed. Subsequently, the remaining photoresist is stripped.

Following this, an organic dielectric laminate such as a polyimide, epoxy, glass-filled polyimide or a glass-filled epoxy prepreg is applied to the resistive material side. The organic dielectric laminate protects the now-patterned resistive material layer from further processing and subsequently supports patches of the resistive material layer when portions of the conductive foil is subsequently removed from the other side of the resistive material layer.

Next, a photoresist layer is applied to the conductive foil. This is imaged with patterned actinic radiation and developed. Following this, the conductive foil is etched with an etchant which selectively etches the conductive foil but which does not etch the resistive material layer. Stripping of the photoresist leaves the resistor which may subsequently be embedded in an organic dielectric material, such as a B-staged dielectric material including, but not limited to, epoxies, polyimides, glass-filed epoxies and polyimides, and the like.

As a variation of this process, it should be noted that if an etchant is used which selectively etches the electrically resistive material layer but does not etch or only partially etches the conductive foil, the use of a resist layer on the conductive foil is not necessary.

When referring herein to "etching", the term is used to denote not only the common usage in this art where a strong chemical dissolves or otherwise removes the material of one of the layers, e.g., nitric acid dissolves nickel, but also physical removal, such as laser removal and removal by lack of adhesion. In this regard, and in accordance with an aspect of this invention, it is found that resistive materials, such as doped nickel and doped platinum, deposited by CCVD or CACCVD are porous. The pores are believed to be small, typically of a diameter of a micron or less, preferably of a diameter of 50 nanometers or less (1000 nm = 1 µm). Nevertheless, this permits liquid etchants to diffuse through the electrically resistive material layer and, in a physical process, destroy the adhesion between the resistive material layer and the underlying layer. For example, if the conductive foil layer is copper and the resistive material layer is doped platinum, e.g., platinum/silica, or doped nickel, e.g., Ni/PO₄, cupric chloride could be used to remove exposed portions of the resistive material layer. The cupric chloride does not dissolve either platinum or nickel, but the porosity of the resistive material layer allows the cupric chloride to reach the underlying copper. A small portion of the copper dissolves and the exposed portions of the electrically resistive layer by physical ablation. This physical ablation occurs before the cupric chloride etches the underlying copper layer to any significant extent.

If copper is the conductive material layer, it is sometimes advantageous to use copper foil that has been oxidized, which is commercially available. An advantage of an oxidized copper foil is that a dilute hydrochloric acid ("HCl") solution, e.g., ½ %, dissolves copper oxide without dissolving zero valence copper. Thus, if the electrically resistive material layer is porous, such that the dilute HCl solution diffuses therethrough, HCl can be used for ablative etching. Dissolving the surface copper oxide destroys the adhesion between the copper foil and the electrically resistive material layer.

To minimize processing steps, the photoresists used can themselves be embeddable in materials, such as a permanent etch resist such as that available from Shipley Company, Marlborough, Massachusetts. Then both sides can be processed simultaneously if the etchant does not or only partially etches the conductor. In particular, only the resistor material side photoresist needs to be embeddable and the conductor side can be removed as a final processing step. Alternatively, the photoresists used on the conductor material side can be selected such that it is not removed with a specific stripper used to remove the resistor material side photoresist. Embedable photoresist may decrease tolerance losses due to particular undercutting of resistor material which under cut material will ablate once the photoresist is removed.

To be practically removable by an ablative technique, the resistive material layer must generally be sufficiently porous to an etchant which does not dissolve the electrically resistive material but sufficiently attacks the surface of the underlying material such as to result in loss of interfacial adhesion and ablation of the electrically conductive material within about 2 to 5 minutes. At the same time, such etchant must not substantially attack the underlying material, e.g., copper foil, during the etching period as such would cause excessive undercutting or loss of mechanical strength (i.e., reduce handleability).

The present invention provides a three-layer structure which comprises an insulating substrate, a layer of perforated resistive material, e.g., platinum/silica formed in accordance with the invention by CCVD, and a conductive layer, e.g., copper. In one embodiment, both perforated resistive material patches and electrical connection conductive patches (i.e. electrodes) are formed by photoimaging techniques.

The three-layer structure might be patterned in one of two two-step procedures by photoimaging technology. In one procedure, the conductive material layer would be covered with a resist, the resist patterned by photoimaging techniques, and, in the exposed areas of the resist, both the conductive material layer and the underlying resistive material layer be etched away, e.g., with aqua regia to give a structure of having a patterned structured resistive material patch (and a patterned conductive material patch). Next, a second photoresist would be applied, photoimaged, and developed. This time, only the exposed portions of the conductive material patch would be etched away by etchant which would selectively etch the conductive layer, but not the resistive material patch, i.e., FeCl₃ or CuCl₂ in the case of copper as the conductive material layer and platinum/silica as the electrically resistive material. In an alternate procedure, a patterned resist layer would be formed, exposed portions of the conductive material layer etched away, e.g., with FeCl₃, a further patterned resist layer formed, and then the exposed areas of the resistive material layer etched away with aqua regia so as to form the electrical contacts. By either procedure, discrete thin layer resistors are formed by conventional photoimaging techniques common to printed circuitry formation.

Accordingly, the present invention provides a resistor having a resistive material and a pair of electrodes, each electrode being disposed at opposite ends of the resistive material, wherein the resistive material has a plurality of perforations. While the present resistors could be at the surface of a printed circuit board device, the resistors will, in most cases, be embedded within a multi-layer printed circuit board, for example where the resistor, which was formed on an organic dielectric substrate, such as polyimide, is embedded within additional embedding organic insulating material layers, such as epoxy or glass-filled epoxy prepreg material.

Resistors containing the present perforated resistive materials may be used in the manufacture of electronic devices, and particularly as resistors embedded in a dielectric material. Thus, the present invention provides an electronic device including a resistor having a resistive material and a pair of electrodes, each electrode being disposed at opposite ends of the resistive material, wherein the resistive material has a plurality of perforations.

In particular, the present resistors are suitable for embedding in a dielectric material in the manufacture of printed wiring boards. Therefore, the present invention also provides an electronic device including a printed wiring board including a resistor having a resistive material and a pair of electrodes, each electrode being disposed at opposite ends of the resistive material, wherein the resistive material has a plurality of perforations. Also provided by the present invention is an electronic device including a resistor, the resistor including a pair of electrodes, each electrode being disposed at opposite ends of the resistive material, the resistive material having a plurality of perforations selected from circular, trapezoidal, polygonal, square, rectangular, elliptical and mixtures thereof. A method of manufacturing a printed wiring board is also provided, the method including the steps of applying a resistor having a resistive material having a plurality of perforations to a printed wiring board substrate, and then applying a layer of an organic dielectric material over the resistor. Preferably, the resistor is applied to a first organic dielectric material disposed on the printed wiring board substrate.

The present invention also provides a method of changing the resistivity of a resistive material layer comprising the step of forming perforations in the resistive material. Such perforations are formed by any of the methods described above.

## Claims

1. A resistor having a resistive material and a pair of electrodes, each electrode being disposed at opposite ends of the resistive material, the resistive material having a plurality of perforations.

2. The resistor of claim 1 wherein the perforations are selected from the group consisting of circular, trapezoidal, polygonal, square, rectangular, elliptical and mixtures thereof.

3. The resistor of any one of claims 1 to 2 wherein the electrodes comprise a metal selected from the group consisting of copper, gold, silver, nickel, tin, platinum, lead, aluminum and mixtures and alloys thereof.

4. The resistor of any one of claims 1 to 3 wherein the resistive material comprises a mixture of a conductive material and a dielectric material.

5. The resistor of claim 4 wherein the resistive material comprises from 0.1 to 20 wt% of the dielectric material

6. The resistor of any one of claims 1 to 5 wherein the resistive material comprises a nickel-based or platinum-based material.

7. A printed wiring board comprising a resistor any one of claims 1 to 6.

8. An electronic device comprising the printed wiring board of claim 7.

9. A method of manufacturing a printed wiring board comprising the steps of: applying a resistor any one of claims 1 to 6 to a printed wiring board substrate; and then applying a layer of an organic dielectric material over the resistor.

10. A method of changing the resistivity of a resistive material layer comprising the step of providing perforations in the resistive material.
